# EUROPEAN PATENT SPECIFICATION

(11) **EP 0 757 220 B1**
(45) Date of publication and mention of the grant of the patent: **10.01.2001**
(21) Application number: 96301976.5
(22) Date of filing: 22.03.1996
(51) Int. Cl.: F28F 3/04

(54) **Radiating fins and method for manufacturing the same**
Strahlungsrippen und Verfahren zu deren Herstellung
Aillettes de radiation et méthode pour leur production

(30) Priority: 26.07.1995 JP 19040995
(43) Date of publication of application: 05.02.1997
(73) Proprietor: MA Fabtec Co., Ltd., Minato-ku, Tokyo 105 (JP); MITSUBISHI ALUMINUM CO.,LTD., Minato-ku, Tokyo 105 (JP)
(72) Inventor: Takemura, Hiroshi, Setagaya-ku, Tokyo 156 (JP); Sueki, Yasuhito, Mishima-shi, Shizuoka 411 (JP)
(74) Representative: Cooper, John

(56) References cited:
- EP-A- 0 632 686
- DE-A- 4 428 170
- US-A- 5 435 384

## Description

### FIELD OF THE INVENTION

This invention relates to a radiating fin assembly and a method for manufacturing the same, and more particularly radiating fins which can carry out forced cooling of various radiating portions by means of cooling fluid such as air flowing through fans and the like.

### BACKGROUND OF THE INVENTION

In general, radiating fins called heat sink which can forcedly cool radiating portions by forcedly circulating fluid such as air by means of fans and the like are used in various radiating portions in inverter, thyristor, transistor, machine tools and the like.

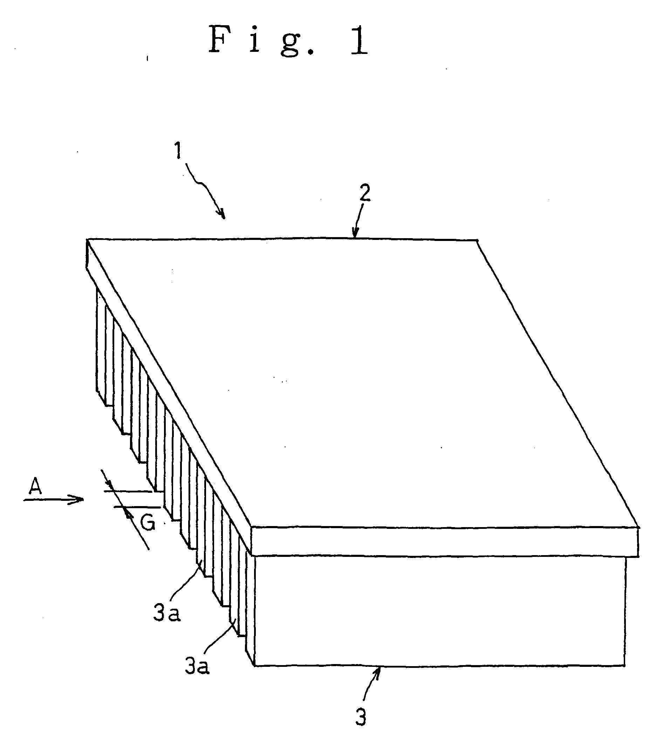

An example of this type of heretofore known radiating fins is described below with reference to Fig.1.

Fig.1 is a perspective view of essential portion of a heretofore known radiating fin assembly.

As shown in Fig.1, heretofore known radiating fin assembly 1 has a plane and substantially rectangular base plate 2 on which radiating portions of electronic devices such as for example thyristor, transistor (not shown) and the like are secured, and fin body 3 comprising a number of fins 3a each having a plane plate form which are planted in said base plate 2.

In this construction, said fins 3a constituting fin body 3 are arranged substantially parallel to each other with their side faces being opposed to each other and with a desired gap G with respect to the flowing direction A of desired cooling fluid such as air which is forcedly blown through fan (not shown) and the like means as shown in Fig.1.

In the recent industries, higher performance and down sizing of various devices are searched, and this is also the requisite for known radiating fins 1. For the purpose of higher performance and down sizing, it is desirable to increase the arranging density of fins 3a on base plate 2 by narrowing said gap G thereby to extend the available surface of fin body 3 and to increase the number of fins 3a held on base plate 2. However, even in such a high density of fins 3a on base plate 2, increase of the number of fins 3a is limited, and a narrowed gap G increases venting resistance (pressure loss) of cooling fluid flowing there through, with decrease of flowing quantity of cooling fluid and with less cooling efficiency.

For preventing the above problems, the present invention provides a radiating fin assembly with a simple and down sized structure having a higher cooling efficiency and performance, and method for manufacturing such a radiating fin assembly.

### SUMMARY OF THE INVENTION

For attaining the above described objects, the present invention provides a radiating fin assembly comprising the features as claimed in Claim 1.
The invention further provides a method of manufacturing a radiating fin assembly as claimed in Claim 6. Particular embodiments of the invention are described in the dependent claims.

Said radiating fin assembly of structure described above according to the invention has such advantages as decrease of flowing resistance (pressure loss) and increase of cooling efficiency. Fin body of said radiating fin assembly is made from aluminium and its alloys with the advantage of decrease of its weight. The manufacture of radiating fin assembly according to the invention readily allows arrangement of fins on a base plate with a higher density and results in the radiating fin assembly having a higher cooling efficiency.

### BRIEF DESCRIPTION OF THE DRAWINGS

Fig. 1 is a perspective view of essential portion of a heretofore known radiating fin assembly.
Fig. 2 is a perspective view of the whole essential portion of the first embodiment of radiating fin assembly according to the invention.
Fig. 3 is a partially enlarged cross sectional view of Fig. 2,
Fig. 4 is a front view of fin body shown in Fig. 2,
Fig.5 is an enlarged longitudinal sectional view taken along line B-B in Fig.4,
Fig.6 is an enlarged cross sectional view taken along line C-C in Fig.4,
Figs.7(a) and 7(b) are enlarged cross sectional views showing variations of bevels shown in Fig.6,
Fig.8 is a block diagram showing an exemplary embodiment of the manufacturing process of radiating fin assembly according to the invention,
Fig.9 is an enlarged longitudinal sectional view of the essential portion of the second embodiment of radiating fin assembly according to the invention, and
Fig.10 is an enlarged cross sectional view of the essential portion of the second embodiment of radiating fin assembly according to the invention.

### DETAILED DESCRIPTION OF THE EMBODIMENTS

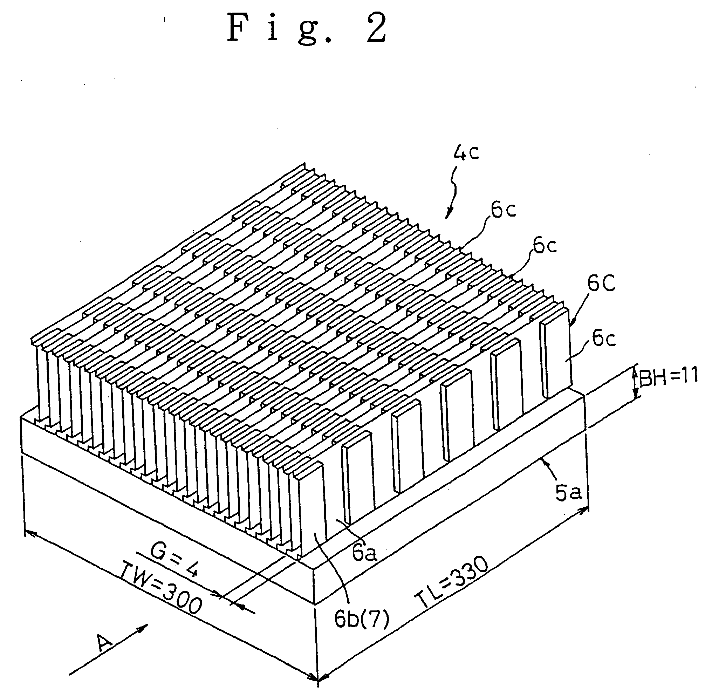

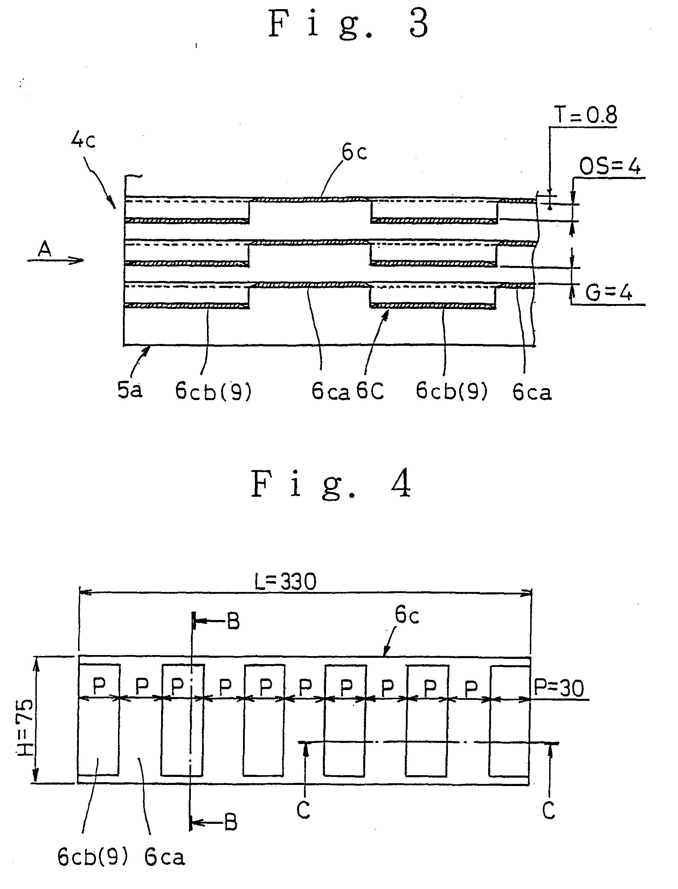

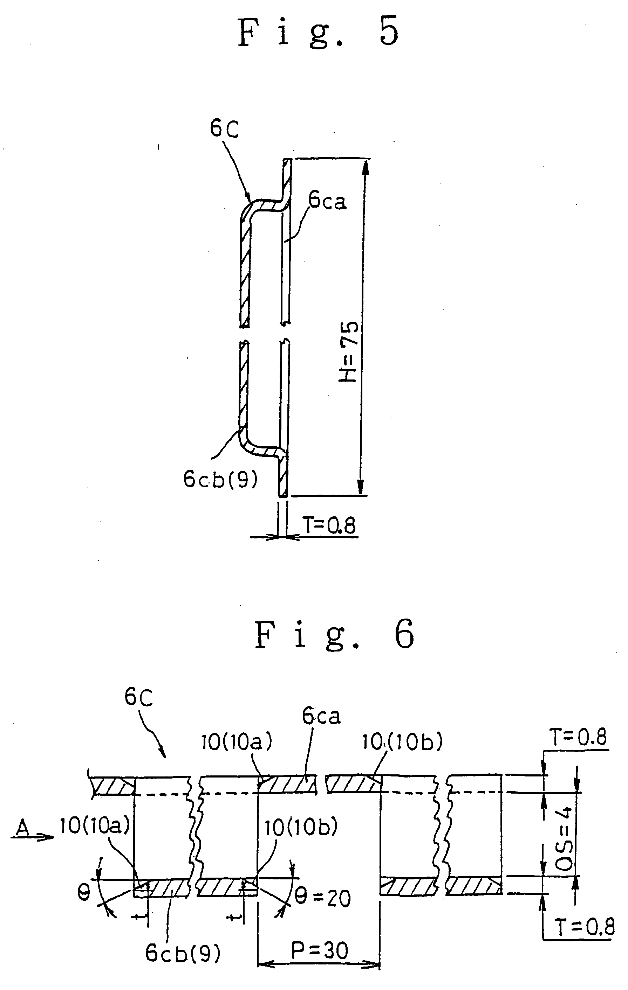

Figs.2 to 6 show the first embodiment of radiating fin assembly according to the invention, in which Fig.2 is a perspective view of the whole essential portion of said assembly, Fig.3 is a partially enlarged cross sectional view of the structure shown in Fig.2, Fig.4 is a front view of a fin body, Fig.5 is an enlarged longitudinal sectional view taken along line B-B in Fig.4 and Fig.6 is an enlarged cross sectional view taken along line C-C in the same Fig.4.

As shown in Fig.2 and Fig.3, the radiating fin assembly 4c has a plane and substantially square base plate 5a to be attached to electronic devices (not shown) such as thyristor or transistor, said base plate having a longitudinal size TW of 200 mm to 400 mm, 300 mm in this embodiment (TW=300), lateral size TL 300 mm to 360 mm, 330 mm in this embodiment (TL=330) and height BH of about 8 mm to 12 mm, 11 mm in this embodiment (BH=11), and fin body 6C comprising a plurality of substantial plane fins 6c planted on the upper surface of base plate 5a.

Said fins 6c are arranged in parallel relation (along with the flowing direction of cooling liquid) to the flowing direction A of cooling liquid and to each other with their side surfaces opposing to each other and with a gap S therebetween of about 8.8 mm (S=8.8) in the direction perpendicular to the flowing direction A.

Further, base plate 5a can have any suitable shape corresponding to that of radiating parts of electronic device, such as for example plane square form, plane oval form, plane circular form, H-form, place rectangular form or others, without restriction to this embodiment. It is the same with the size of base plate 5a.

As shown in Fig.3 to Fig.6, fins 6c have each a plane plate form having width (thickness) T perpendicular to the flowing direction A of width T of about 0.8mm (T=0.8), length L parallel to the flowing direction A of about 330 mm (L=300) and height H measured in the direction of the height of base plate 5a of about 75mm (H=75).

Each fin 6c comprises a plurality of first fin sections 6ca arranged with a longitudinal gap P, about 30mm (P=30) in this embodiment, and a plurality of second fin sections 6cb which are offset from said first sections 6ca with offset distance OS of about 4mm (OS=4).

The opposite ends of fin 6c have respectively second fin sections 6cb thereon, and second fin sections 6cb and first fin sections 6ca are alternately arranged from the upper side to the lower side in the flowing direction A of cooling liquid.

More specifically, approximately rectangular projects 9 having height of about 4 mm are arranged on the surface of fins 6c as shown in Fig.4 with gaps P of about 30 mm between them. Said projects 9 comprise respectively second fin sections 6cb. Alternately with said second fin sections 6cb, there are arranged first fin sections 6ca with offset OS of about 4mm with respect to the row of said second fin sections 6cb.

In such a structure, first fin sections 6ca and second fin sections 6cb are alternately and longitudinally arranged on the surface of fins 6c.

In other words, in the radiating fin assembly 4c, base plate 5a has arranged thereon a plurality of substantially plane plate form like fin s 6c, said fins 6c being each parallel to the flowing direction A of cooling liquid and being stacked on each other in the direction perpendicular to said flowing direction A. Said fins 6c each comprises first fin sections 6ca arranged with gap P in a plane parallel to said flowing direction A and second fin sections 6cb arranged alternately with said first fin sections 6ca in second plane offset from said first plane.

Accordingly, as shown in Fig.3, radiating fin assembly 4c according to this embodiment has first fin sections 6ca and second fin sections 6cb arranged in respective lines planted on base plate 5a. That is to say, rows comprising respectively first fin sections 6ca and rows comprising respectively second fin sections 6cb are alternately arranged with offset OS (OS=4) and with gap G (G=4) between two adjacent rows. This gap G between two types of rows corresponds to said gap G in the heretofore known radiating fin assembly 1.

Fins 6c as shown in Fig.4 have arranged thereon first fin sections 6ca and second fin sections 6cb, each fin sections connecting to the both side edges of fins 6c. However, said fins 6c can comprise two rows of first and second fin sections having respectively one ends thereof connected only to their corresponding side edge of said fins 6c just like as combs, so the structure of this embodiment is not restricted to that shown in Fig.4.

As shown in Fig.4, first and second fin sections 6ca, 6cb have each thereon bevels 10 having an angle of θ just like as bevels 7 said fin body 6a of first embodiment, respectively on the head side and the tail side to the flowing direction of cooling fluid. The bevels 10a, 10b on the head side and the tail side are located respectively on the upper sides of corresponding fin sections 6ca and 6cb as shown in Fig.4.

Said bevel 10a has a width t in the direction perpendicular to the flowing direction A of cooling liquid, said width t increasing gradually from the upper side to the down side of said flowing direction A, while said bevel 10b has a width t in the direction perpendicular to the flowing direction A, said width t on said bevel 10b decreasing gradually from the upper side to the down side of said flowing direction A.

Further, said bevels 10a, 10b are in plane symmetry relationship with each other with respect to the longitudinal central plane of fins 6c.

The angle θ of bevel 10 is about 20 degrees with respect to the flowing direction A of cooling liquid (θ =20). This angle θ of bevel 10 can be located between 5 to 60 degrees, preferably 15 to 45 degrees without restriction to the θ of 20 degrees.

Further, the angles θ of respective bevels 10a, 10b can be different from each other if necessary.

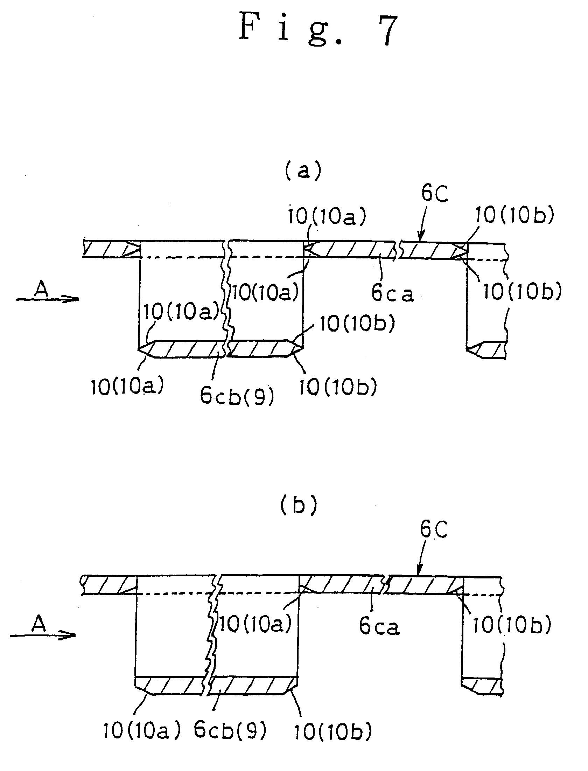

Further, said bevel 10 can be made as double bevels which are symmetrical with respect to respective central vertical planes in first fin sections 6ca and second fin sections 6cb as shown in Fig.7(a), or single bevel 10 (10a, 10b) can be on one side surface (bottom side surface in this figure) respectively of first fin sections 6ca and second fin sections 6cb as shown in Fig.7(b). These structure in Figs. 7(a) and 7(b) can be used solely or in combination, or only in the head side or the tail side of respective fin sections, without restriction to this embodiment. It was found that, when using bevel 10 solely on the head side or tail side of first fin section 6ca or second fin section 6cb, bevel 10 located at the tail side contributes to the increase of cooling efficiency much more than that located at the head side.

Further, it is desirable that the head side edge and/or the tail side edge of a fin 6c which is shown up and down in Fig.5 is provided with a bevel 7 such as shown in the first embodiment.

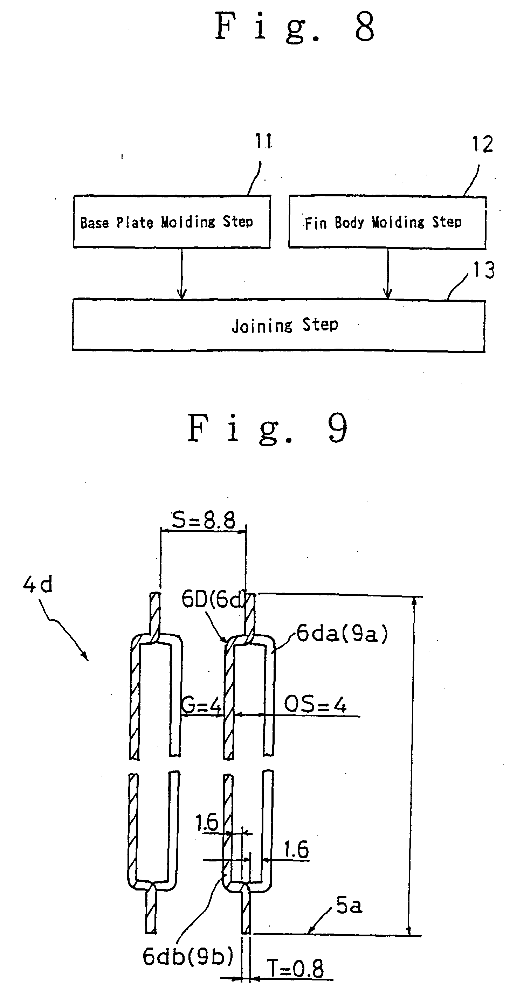

An example of manufacturing process of radiating fin assembly 4c is now described with reference to Fig.8.

Fig.8 shows a block diagram of manufacturing process of radiating fin assembly according to the invention.

As shown in Fig.8, the manufacturing process of radiating fin assembly 4c comprises separately base plate molding step 11 for forming base plate 5a, fin body molding step 12 for forming fin body 6C, and joining step 13 for joining a fin body 6C obtained from the fin body molding step 12 onto a base plate 5a obtained from said base plate molding step 11.

More specifically, said base plate molding step 11 is a step for forming base plate 5a by carrying out plastic deformation such as well known extrusion or forging onto metal materials such as aluminium or its alloys by means of metal molds (not shown) having specific molding shape, thereby to obtain plane and substantially square base plate 5a having a longitudinal size TW of 200 mm to 400 mm, 300 mm in this embodiment (TW=300), lateral size TL 300 mm to 360 mm, 330 mm in this embodiment (TL=330) and height BH of about 8 mm to 12 mm, 11 mm in this embodiment (BH=11).

Further, various types of machining such as cutting and grinding can be carried out on the obtained base plate member. Any suitable materials having high heat conductivity such as copper, copper alloys, magnesium or its alloys can be used for the metal materials for base plate 5a. The other process for forming base plate 5a is casting process such as die casting or squeeze casting in which metallic materials such as aluminium or its alloys in its molten state are poured into mold having specific shape (not shown) and then if necessary a machining such as cutting or grinding is carried out on the resulting intermediate pieces.

Said fin forming process 12 comprises well known plastic deformation such as extrusion, forging or press working and various machining such as cutting and the like on metal materials such as aluminium or its alloys by means of metal mold (not shown) having specific shape, thereby to obtain plate like work having a width (thickness) T of about 0.8mm (T=0.8), length L about 330 mm (L=330) and height H measured in the direction of the height of base plate 5a of about 75mm (H=75), and a further plastic deformation can be carried out onto said work, such as press working by means of metal mold (not shown), thereby to form first fin sections 6ca, second fin sections 6cb and bevel 10 simultaneously, thus resulting in a complete work (fins 6c).

In other words, this embodiment of manufacturing process comprises the first step of plastically deforming a plurality of longitudinal sections in metallic plate having approximately plane plate form thereby to form a plurality of second fin sections 6cb with a longitudinal distance P between them, said second fin sections being parallel to and remote from the main plain of said metallic plate and being connected to said metallic plate only in the vicinity of longitudinal edge or edges of said metallic plate, and thus to form a plurality of first fin sections 6ca in the longitudinal portions of said metallic plate which have none of said second fin sections 6cb, thus to obtain fins 6c, and simultaneously with said plastic deformation, a second step of forming bevel 10a on the head side of said first fin sections 6ca and said second fin sections 6cb in the flowing direction of cooling liquid, said bevel 10a on the head side having a width t perpendicular to said flowing direction increasing from the upper side to the down side of said flowing direction and forming bevel 10b on the tail side of said first fin sections 6ca and said second fin sections 6cb in the flowing direction of cooling liquid, said bevel 10b on the tail side having a width t perpendicular to said flowing direction decreasing from the upper side to the down side of said flowing direction, thus to obtain a complete fins 6c.

In this embodiment, presence or absence, position and shape of said bevel 10 can be easily controlled by changing the shape of cavity of used metal mold (not shown).

Any suitable materials other than aluminium or its alloys having high heat conductivity such as copper, copper alloys, magnesium or its alloys can be used in the scope of the present invention for the metal materials for said fins 6c.

When carrying out said fin body forming process 12 for forming fins 6c, casting process such as die casting or squeeze casting in which metallic materials such as aluminium or its alloys in its molten state are poured into mold having specific shape (not shown) and then if necessary a machining such as cutting or grinding is carried out on the resulting intermediate pieces.

Further, in the above described fin body making process 12, the work making step and the bevel forming step on said first and second fin sections 6ca, 6cb are separated from each other, but these two steps can be carried out in a single step. Fins 6c can be formed also by press working of hoop or sketch materials.

Said joining process 13 comprises the step of joining a plurality of fins 6c constituting fin body 6C onto the predetermined portions of base plate 5a by means of welding such as brazing so as to arrange said fins 6c in the direction of cooling liquid, thereby to form fin body 6C to obtain complete radiating fin 4c.

When joining a plurality of fins 6c on base plate 5a, these fins 6c are arranged in parallel relationship with said first fin sections 6ca and second fin sections 6cb opposing to each other and with a gap G (G=4) equal to said offset OS (OS=4) of said first and second fin sections 6ca, 6cb. That is to say, first fin sections 6ca and second fin sections 6cb of each fin 6c are respectively offset from their opposing sections 6ca and 6cb of adjacent fin 6c with a gap S(S=8.8mm) which corresponds to two times of offset OS plus thickness T of fin 6c.

While base plate 5a and a plurality of fins 6c constituting fin body 6C are separately formed and the resulting base plate 5a and fins 6c are joined together there by to form a radiating fin assembly 4c in the above embodiment, otherwise casting technics such as die casting or squeeze casting can be carried out, wherein aluminium or its alloys in molten state can be poured into a metal mold (not shown) having a cavity corresponding to the shape of radiating fin assembly 4c thereby to form together base plate 5a and fins 6c and then necessary machining such as cutting or grinding can be carried out.

Operation of the structure according to the above embodiment is described herein below.

Since fin body 6C of radiating fin assembly 4c comprises a plurality of fins 6c arranged on base plate and said fins 6c have each two rows of first fin sections 6ca and second fin sections 6cb in alternate and offset arrangement, a higher density of fins 6c on base plate 5a can be easily obtained with higher cooling efficiency than that of heretofore known radiating fin assembly 1.

More specifically, it was found by our experiments that, with a radiating fin assembly 4c of the present invention having the same surface area of fins 6c as that of heretofore known fins 3a (number of rows being two times larger than that of known fins 3a), coefficient of heat transfer k (W/m² ° K) becomes 1.2 to 1.5 times larger than that of heretofore known plane fins 3a. This coefficient of heat transfer k can be increased by increasing the surface area of solid used, but only the increase of surface area brings about inconveniences as in the heretofore known devices.

According to the above embodiment, the cooling efficiency of said radiating fin assembly 4c is improved and said radiating fin assembly 4c is certainly become efficient by providing first fin sections 6ca and second fin sections 6cb in offset arrangement in said fins 6c. Although flowing resistance of cooling liquid is increased when passing by first fin sections 6ca and second fin sections 6cb in offset arrangement, said bevels 10 on these fin sections can prevent said flowing resistance from in creasing, so that a higher density of fins 6c on base plate 5a can be obtained.

Said bevels 10 may be provided in the case where said flowing resistance is increased, but they need not be provided in the case where said flowing resistance is not increased.

Further, since said bevels 10 are provided both on head side and on tail side of first fin sections 6ca and second fin sections 6cb in the flowing direction of cooling liquid, the function of preventing increase of flowing resistance of cooling liquid can be assured even when fins 6c have been erroneously arranged in head and tail direction.

The optimum values (values for which cooling efficiency becomes maximum) for said gap P in the flowing direction, said gap G between first fin section 6ca and second fin section 6cb, equal to offset distance OS and thickness T of fin 6c have found by our experiments. For a gap P of about 10 to 40 mm, offset OS of about 2 to 6 mm, and thickness T of about 0.6 to 1.2 mm, a ratio of P/OS of about 6 to 12 has been determined as a most efficient range for obtaining increase of cooling efficiency.

Further, since fins 6c of radiating fin assembly 4c according to the invention comprising first fin sections 6ca and second fin sections 6cb, one joining operation of a row of fin 6c according to the invention corresponds to two joining operations of two rows of heretofore known fin 3a, so that the efficiency of joining operation is positively increased with decrease of operating labor.

Further, since radiating fin assembly 4c uses aluminium or its alloys as starting materials, weight of obtained fin assembly is positively decreased.

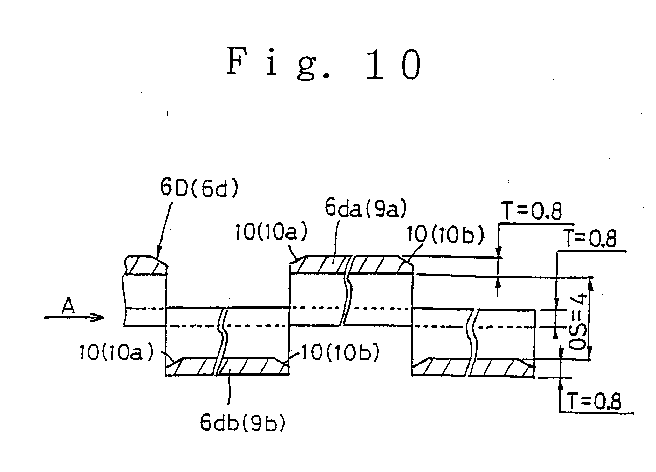

With reference to Figs.9 and 10 showing the essential portion of the second embodiment of radiating fin assembly according to the invention, fins 6d constituting fin body 6D of radiating fin assembly 4d according to the invention have each approximately rectangular protrusions 9a having respectively height of about 2 mm, 1.6 mm in this embodiment, on the one side surface thereof with gap P of about 30 mm between them, said protrusions 9a comprising first fin sections 6da as shown on the right side in Fig.9 and on the upper side in Fig.10.

Said fins 6d have each approximately rectangular protrusions 9b having respectively height of about 2 mm, 1.6 mm in this embodiment, on the other side surface thereof with gap P of about 30 mm between them, said protrusions 9b comprising second fin sections 6db as shown on the left side in Fig.8 and on the lower side in Fig.10.

In such a construction, said first fin sections 6da and said second fin section 6db are alternately arranged in parallel relationship to each other, with offset OS of about 4 mm (OS=4).

Such a radiating fin assembly 4d has a same performance as that of said fin assembly 4c of the first embodiment, and a larger offset OS can be obtained owing to the first and second fin sections 6da, 6db protruding in the reverse directions.

Further, radiating fin assembly 4d can be easily manufactured by changing the cavity shape of metallic mold used in said fin forming step 12 for radiating fin assembly 4c of the first embodiment.

In other words, the manufacturing process of radiating fin assembly 4d according to this embodiment comprises the first step of plastically deforming a plurality of longitudinal sections in metallic plate having approximately plane plate thereby to form a plurality of first fin sections 6da with a longitudinal distance P between them, said first fin sections 6da being parallel to and remote from the main plain of said metallic plate and being connected to said metallic plate only in the vicinity of longitudinal edge or edges of said metallic plate, and to form a plurality of second fin sections 6db by plastically deforming the longitudinal portions of said metallic plate which have none of said first fin sections 6da with a longitudinal distance P between them, said second fin sections 6db being parallel to and remote from the main plain of said metallic plate in the direction reverse to that of said first fin sections 6da and being connected to said metallic plate in the vicinity of longitudinal edge or edges of said metallic plate, thus to obtain fins 6d, and simultaneously with said plastic deformation, a second step of forming bevel 10a on the head side of said first fin sections 6da and said second fin sections 6db in the flowing direction of cooling liquid, said bevel 10a on the head side having a width t perpendicular to said flowing direction increasing from the upper side to the down side of said flowing direction and forming bevel 10b on the tail side of said first fin sections 6da and said second fin sections 6db in the flowing direction of cooling liquid, said bevel 10b on the tail side having a width t perpendicular to said flowing direction decreasing from the upper side to the down side of said flowing direction, thus to obtain a complete fins 6d.

Other features of this process are the same those of manufacturing process of radiating fin assembly 4c according to the first embodiment.

In the manufacturing process of this radiating fin assembly 4d according to this embodiment, the same advantages of the process of radiating fins assembly 4c according to said first embodiment are obtained, and when offset OS between said first fin sections 6da and said second fin sections 6db is about 4 mm, i.e. the same offset value OS as that of said first fin sections 6ca and said second fin sections 6cb according to the first embodiment, the bending portions in said metallic plate becomes 2 times larger than that in said first embodiment, but the extent of plastic deformation at the portions connecting said first and second fin sections 6da, 6db to the vicinity of longitudinal edge of said metallic plate becomes half or lower.

As a result, load necessary to plastic deformation of metallic plate can be decreased, so that the life of metallic mold used for the plastic deformation can be increased, and that working and residual strains for the formation of said first and second fin sections 6da, 6db can be consider ably decreased with a positively increased working accuracy and size accuracy.

While the present invention has been described with reference to exemplary embodiments thereof, it will be appreciated by those skilled in the art that variations and modifications may be made thereto.

When using radiating fin assembly according to the invention, various advantages such as decrease of flowing resistance (pressure loss) of cooling liquid, increase of cooling efficiency, higher performance and down sizing are obtained. Further, provision of first and second fin sections offset disposed onto base plate allows easier high density arrangement of fins on base plate with a higher cooling efficiency and performance. Further, bevels disposed on first and second fin sections have an advantage of positively reducing increase of flowing resistance. The manufacturing process of radiating fin assembly according to the invention allows readily obtaining of radiating fin assembly having offset fin sections as described above.

## Claims

1. Radiating fin assembly (4a) comprising a base plate (5a) and a fin body (6C) held on said base plate (5a), in which said fin body (6c) is constituted from a plurality of substantially plane plate like fins (6c) characterized in that said fins (6c) extend each in a first direction, said fins being arranged or stacked in a second direction perpendicular to the first direction, said fins (6c) have each thereon a plurality of first fin sections (6ca) arranged in a same plane with determined gaps therebetween and a plurality of second fin (6cb) sections located each in the portions having none of said first fin sections, said second fin sections (6cb) being arranged in a plane offset from the plane of said first fin sections in said second direction.

2. Radiating fin assembly according to Claim 1, characterized in that bevels (10a) are formed on the head side and/or the tail side of said first and second fin sections, said bevels (10a) formed on the head side having a width perpendicular to the flowing direction increasing from the upper side to the down side, while said bevels (10a) formed on the tail side having a width perpendicular to the flowing direction decreasing from the upper side to the down side.

3. Radiating fin assembly according to claim 2, characterized in that said bevels (10a) are formed in plane symmetry manner with respect to their central vertical plane in their width perpendicular to the flowing direction of cooling fluid in said first and second fin sections.

4. Radiating fin assembly according to Claim 2 or 3, characterized in that the angle of said bevels (10a) is ranged at an angle of from 5 to 60 degrees with respect to said flowing direction of cooling fluid.

5. Radiating fin assembly according to any one of Claims 1 to 4, characterized in that said fin body (6c) is made from aluminium or its alloys.

6. A method of manufacturing a radiating fin assembly (4c) characterized by the step of plastically deforming a plurality of longitudinal portions in a metallic plate having an approximately plane plate form thereby to form a plurality of second fin (6cb) sections with a determined longitudinal distance between them, said second fin (6cb) sections being parallel to and remote from the main plain of said metallic plate in the direction of said metallic plate and being connected to said metallic plate only in the vicinity of longitudinal edge or edges of said metallic plate, and thus to form a plurality of first fin (6ca) sections in the longitudinal portions of said metallic plate which have none of said second fin (6cb) sections, thereby to arrange said fins on said base plate (5a) in the flowing direction of cooling fluid.

7. A method of manufacturing a radiating fin assembly according to Claim 6 characterized by said first fins being plastically deformed such that said first fin sections (6ca) are parallel to and remote from the plain of the metallic plate in a direction reverse to that of said second fin sections (6cb) and are connected to said metallic plate in the vicinity of said longitudinal edge or edges of said metallic plate.

8. A method of manufacturing a radiating fin assembly according to Claims 6 and 7, characterized in that simultaneously with said forming of first (6cb) and second (6ca) fin sections by plastically deforming a plurality of longitudinal portions of said metallic plate having substantially plane plate form, bevel (10a) or bevels are formed on the head side and/or tail side of said first (6cb) and second (6ca) fin sections in the flowing direction of cooling fluid.

## Patentansprüche

1. Eine Strahlungsrippenanordnung (4a), bestehend aus einer Basisplatte (5a) und einem Rippenkörper (6C), der an der Basisplatte (5a) befestigt ist, wobei der Rippenkörper (6C) aus einer Vielzahl von im wesentlichen ebenen, plattenähnlichen Rippen (6c) besteht, dadurch gekennzeichnet, daß diese Rippen (6c) sich jeweils in eine erste Richtung erstrecken, wobei die Rippen in eine zweite Richtung, senkrecht zur ersten Richtung angeordnet oder gestapelt werden,
wobei diese Rippen (6c) jeweils eine Vielzahl von ersten Rippenabschnitten (6ca), die in derselben Ebene und mit vorgegebenen Zwischenräumen dazwischen angeordnet sind, und eine Vielzahl von zweiten Rippenabschnitten (6cb), die jeweils in den Abschnitten, welche die ersten Rippenabschnitte nicht aufweisen, befindlich sind, aufweisen, wobei die zweiten Rippenabschnitte (6cb) in die zweite Richtung in einer Ebene angeordnet sind, die zur Ebene der ersten Rippenabschnitte versetzt ist.

2. Strahlungsrippenanordnung gemäß Anspruch 1, dadurch gekennzeichnet, daß Schrägkanten (10a) auf der vorderen und/oder hinteren Seite der ersten und zweiten Rippenabschnitte gebildet sind, wobei die auf der vorderen Seite gebildeten Schrägkanten (10a) eine Breite aufweisen, die senkrecht zur Fließrichtung liegt und von der oberen Seite zur unteren Seite hin zunimmt, wobei die auf der hinteren Seite gebildeten Schrägkanten (10a) eine Breite aufweisen, die senkrecht zur Fließrichtung liegt und von der oberen Seite zur unteren Seite hin abnimmt.

3. Strahlungsrippenanordnung gemäß Anspruch 2, dadurch gekennzeichnet, daß die Schrägkanten (10a) hinsichtlich ihrer zentralen senkrechten Ebene in ihrer zur Fließrichtung der Kühlflüssigkeit in den ersten und zweiten Rippenabschnitten senkrechten Breite in der Ebene symmetrisch geformt sind.

4. Strahlungsrippenanordnung gemäß Anspruch 2 oder 3, dadurch gekennzeichnet, daß der Winkel der Schrägkanten (10a), hinsichtlich der Fließrichtung der Kühlflüssigkeit, zwischen 5 und 60 Grad liegt.

5. Strahlungsrippenanordnung gemäß einem der Ansprüche 1 bis 4, dadurch gekennzeichnet, daß der Rippenkörper (6C) aus Aluminium oder dessen Legierungen besteht.

6. Ein Verfahren zur Herstellung einer Strahlungsrippenanordnung (4c), gekennzeichnet durch den Schritt, eine Vielzahl von Längsteilen in einer Metallplatte mit einer ungefähr ebenen Platte plastisch zu verformen, wodurch eine Vielzahl von zweiten Rippenabschnitten (6cb) mit einem vorgegebenen Zwischenraum gebildet werden, wobei die zweiten Rippenabschnitte (6cb) parallel zu und fern von der Hauptebene der Metallplatte in der Richtung der Metallplatte liegen und nur in der Nähe der Längskante oder -kanten der Metallplatte mit der Metallplatte verbunden sind, wodurch eine Vielzahl von ersten Rippenabschnitten (6ca) in den Längsteilen der Metallplatte, welche die zweiten Rippenabschnitte (6cb) nicht aufweisen, gebildet werden,
wodurch die Rippen in der Fließrichtung der Kühlflüssigkeit auf der Basisplatte (5a) angeordnet werden.

7. Verfahren zur Herstellung einer Strahlungsrippenanordnung gemäß Anspruch 6, dadurch gekennzeichnet, daß die ersten Rippen plastisch verformt werden, so daß die ersten Rippenabschnitte (6ca) parallel zu und fern von der Ebene der Metallplatte in einer der Richtung der zweiten Rippenabschnitte (6cb) entgegengesetzten Richtung liegen und in der Nähe der Längskante oder -kanten der Metallplatte mit der Metallplatte verbunden sind.

8. Verfahren zur Herstellung einer Strahlungsrippenanordnung gemäß Anspruch 6 und 7, dadurch gekennzeichnet, daß gleichzeitig zum Bilden der ersten (6cb) und zweiten (6ca) Rippenabschnitte, indem eine Vielzahl von Längsteilen der Metallplatte, die im wesentlichen die Form einer ebenen Platte aufweist, plastisch verformt wird, eine Schrägkante (10a) oder -kanten auf der vorderen Seite und/oder hinteren Seite der ersten (6cb) und zweiten (6ca) Rippenabschnitte in der Fließrichtung der Kühlflüssigkeit gebildet werden.

## Revendications

1. Assemblage à ailettes radiantes (4a) comprenant une plaque de montage (5a) et un corps à ailettes (6C) maintenu sur ladite plaque de montage (5a), dans lequel ledit corps à ailettes (6C) est constitué d'une pluralité d'ailettes ressemblant à des plaques sensiblement planes (6c) caractérisé en ce que lesdites ailettes (6c) s'étendent chacune dans un premier sens, lesdites ailettes étant agencées ou empilées dans un deuxième sens perpendiculaire au premier sens, en ce que lesdites ailettes (6c) présentent chacune, sur la plaque de montage, une pluralité de premières sections d'ailettes (6ca) agencées dans un même plan et espacées les unes des autres à intervalles déterminés et une pluralité de deuxièmes sections d'ailettes (6cb) situées chacune dans les portions ne présentant aucune desdites premières sections d'ailettes, lesdites deuxièmes sections d'ailettes (6cb) étant agencées dans un plan décalé par rapport au plan desdites premières sections d'ailettes dans ledit deuxième sens.

2. Assemblage à ailettes radiantes selon la revendication 1, caractérisé en ce que des biseaux (10a) sont formés sur le côté de tête et/ou le côté de queue desdites premières et deuxièmes sections d'ailettes, lesdits biseaux (10a) formés sur le côté de tête présentant une largeur perpendiculaire au sens d'écoulement qui va en augmentant du côté amont vers le côté aval, tandis que lesdits biseaux (10a) formés sur le côté de queue présentent une largeur perpendiculaire au sens d'écoulement qui va en diminuant du côté amont vers le côté aval.

3. Assemblage à ailettes radiantes selon la revendication 2, caractérisé en ce que lesdits biseaux (10a) sont formés de manière à présenter une symétrie-plan par rapport à leur plan vertical central dans leur largeur perpendiculaire au sens d'écoulement de fluide de refroidissement dans lesdites premières et deuxièmes sections d'ailettes.

4. Assemblage à ailettes radiantes selon la revendication 2 ou 3, caractérisé en ce que l'angle desdits biseaux (10a) est compris dans la gamme d'angle allant de 5 à 60 degrés par rapport audit sens d'écoulement de fluide de refroidissement.

5. Assemblage à ailettes radiantes selon une quelconque des revendications 1 à 4, caractérisé en ce que ledit corps à ailettes (6C) est réalisé à partir de l'aluminium ou de ses alliages.

6. Un procédé de fabrication d'un assemblage à ailettes radiantes (4c) caractérisé par les étapes consistant à déformer plastiquement une pluralité de portions longitudinales dans une plaque métallique se présentant sous la forme d'une plaque à peu près plane pour former de la sorte une pluralité de deuxièmes sections d'ailettes (6cb) espacées les unes des autres d'une distance longitudinale déterminée, lesdites deuxièmes sections d'ailettes (6cb) étant parallèles à la surface plate principale de ladite plaque métallique et à l'écart de celle-ci dans le sens de ladite plaque métallique et n'étant raccordées à ladite plaque métallique qu'au voisinage du ou des bords longitudinaux de ladite plaque métallique, et pour former ainsi une pluralité de premières sections d'ailettes (6ca) dans les portions longitudinales de ladite plaque métallique qui ne présentent aucune desdites deuxièmes sections d'ailettes (6cb), pour agencer de la sorte lesdites ailettes sur ladite plaque de montage (5a) dans le sens d'écoulement de fluide de refroidissement.

7. Un procédé de fabrication d'un assemblage à ailettes radiantes selon la revendication 6 caractérisé en ce que lesdites premières ailettes sont déformées plastiquement de telle façon que lesdites premières sections d'ailettes (6ca) sont parallèles à la surface plate de la plaque métallique et à l'écart de celle-ci dans un sens inverse à celui desdites deuxièmes sections d'ailettes (6cb) et sont raccordées à ladite plaque métallique au voisinage dudit ou desdits bords longitudinaux de ladite plaque métallique.

8. Un procédé de fabrication d'un assemblage à ailettes radiantes selon les revendications 6 et 7, caractérisé en ce que simultanément à ladite formation des premières (6cb) et deuxièmes (6ca) sections d'ailettes par la déformation plastique d'une pluralité de portions longitudinales de ladite plaque métallique se présentant sous la forme d'une plaque sensiblement plane, le biseau (10a) ou des biseaux sont formés sur le côté de tête et/ou le côté de queue desdites premières (6cb) et deuxièmes (6ca) sections d'ailettes dans le sens d'écoulement de fluide de refroidissement.
